# EUROPÄISCHE PATENTSCHRIFT

(11) **EP 3 417 482 B1**
(45) Veröffentlichungstag und Bekanntmachung des Hinweises auf die Patenterteilung: **04.06.2025**
(21) Anmeldenummer: 16716841.8
(22) Anmeldetag: 06.04.2016
(51) Int. Cl.: H01L 25/11, H02M 7/155, H02M 7/00, H02J 3/36

(54) **ELEKTRISCHE EINRICHTUNG MIT EINER HALBLEITERSCHALTUNG**
ELECTRICAL DEVICE HAVING A SEMICONDUCTOR CIRCUIT
DISPOSITIF ÉLECTRIQUE DOTÉ D'UN CIRCUIT À SEMICONDUCTEURS

(43) Veröffentlichungstag der Anmeldung: 26.12.2018
(73) Patentinhaber: Siemens Energy Global GmbH & Co. KG, 81739 München (DE)
(72) Erfinder: KAPELKE, Martin, 90429 Nürnberg (DE); SUDA, Manfred, 91334 Hemhofen (DE)
(86) Internationale Anmeldenummer: PCT/EP2016/057519
(87) Internationale Veröffentlichungsnummer: WO 2017/174126

(56) Entgegenhaltungen:
- EP-B1- 0 299 275
- DE-A1- 19 841 134
- US-A- 3 878 448
- US-A- 4 218 731

## Beschreibung

Die Erfindung betrifft einen Umrichter mit einer elektrischen Einrichtung mit einer Halbleiterschaltung zwischen einem Wechselspannungsanschluss und einem Gleichspannungsanschluss, die für eine Hochspannung ausgelegt und in einem Gehäuse angeordnet ist.

Ein solcher Umrichter ist aus dem Stand der Technik, insbesondere aus der Hochspannungstechnik, bekannt. Beispielsweise weisen Umrichter zum Umwandeln von Wechselspannung in Gleichspannung oder umgekehrt Umrichterventile auf, die eine Mehrzahl von Leistungshalbleitern umfassen. Die Leistungshalbleiter sind Halbleiterschalter, die für die Hochspannung ausgelegt sind, also für Spannungsdifferenzen oberhalb von 1 kV. Die Leistungshalbleiter sind üblicherweise in einem oder mehreren Gehäusen untergebracht.

Aus der EP 0 299 275 B1 ist beispielsweise ein Stromrichter bekannt, dessen Stromrichterventile Thyristoren umfassen, die in Gehäusen in Form von Modulen angeordnet sind. Die Module sind zu Ventiltürmen zusammengefasst, die in einer Ventilhalle montiert sind. Die Ventilhalle befindet sich auf Erdpotenzial. Im Betrieb des Stromrichters sind die Thyristoren der Halbleiterschaltung demgegenüber auf unterschiedlichen Hochspannungspotenzialen, so dass die Halbleiterschaltung beziehungsweise deren Teile, gegenüber dem Gehäuse bzw. der Gehäusewandung des Moduls elektrisch isoliert werden müssen. Dies geschieht üblicherweise durch Bereitstellung von genügend Abstand zwischen der Halbleiterschaltung beziehungsweise deren Teil und der Gehäusewandung. Dies führt bei hohen Spannungen, die an der Halbleiterschaltung anliegen, zu notwendigerweise großen Abmessungen des Gehäuses. Üblicherweise betragen die Breite und die Länge des Gehäuses bis zu mehreren Metern. Die Zugänglichkeit zur Durchführung von Installations- und Wartungsarbeiten an der Halbleiterschaltung ist dadurch stark erschwert.

Aus der DE 198 41 134 A1 ist ein Umrichter bekannt.

Der Umrichter umfasst eine elektrische Einrichtung mit einer Halbleiterschaltung zwischen einem Wechselspannungsanschluss und einem Gleichspannungsanschluss, die für eine Hochspannung ausgelegt und in einem Gehäuse angeordnet ist, wobei die Halbleiterschaltung eine Reihenschaltung von Leistungshalbleitern aufweist, wobei das Gehäuse ein Modulrahmen ist, an dem die Halbleiterschaltung montiert ist, und mehrere Gehäuseteile umfasst, die Rahmensegmente sind, wobei den Rahmensegmenten unterschiedliche elektrische Potenziale zuweisbar sind.

Die Aufgabe der Erfindung besteht darin, einen artgemäßen Umrichter vorzuschlagen, der eine möglichst einfache Wartung ermöglicht.

Die Aufgabe wird durch einen Umrichter mit den Merkmalen des Patentanspruchs 1 gelöst.

Im Betrieb der erfindungsgemäßen elektrischen Einrichtung können unterschiedliche Gehäuseteile insbesondere jeweils auf ein unterschiedliches, zuvor vorgegebenes elektrisches Potenzial gebracht werden. Dabei kann das jeweilige elektrische Potenzial eines Gehäuseteils an das elektrische Potenzial von in räumlicher Anordnung nächstliegenden Komponenten der Halbleiterschaltung angepasst werden.

Auf diese Weise können vorteilhaft flexible Spannungsdifferenzen zwischen der Halbleiterschaltung und dem Gehäuse erreicht werden. Insbesondere muss beispielsweise eine auf höchstem Spannungsniveau liegende Komponente der Halbleiterschaltung beziehungsweise einem Halbleiterschaltungsteil nicht mehr gegenüber einem gesamten auf Erdpotenzial beziehungsweise auf dem niedrigsten Potenzial des Halbleiterschaltungsteils liegenden Gehäuse, sondern gegenüber einem auf einem vorgegebenen, höheren (Teil-)Potenzial liegenden Gehäuseteil isoliert werden.

Die isolierenden Luftstrecken zwischen der Halbleiterschaltung und dem Gehäuse können vorteilhaft reduziert werden. Dies senkt den Wartungsaufwand durch verbesserten Zugang zu der Halbleiterschaltung erheblich.

Erfindungsgemäß liegt wenigstens ein Gehäuseteil in Betrieb auf einem Hochspannungspotenzial. Dies erlaubt es, bei einer Halbleiterschaltung, an der in Betrieb eine Hochspannung anliegt, die Isolationsabstände besonders gering zu halten. Besteht beispielsweise die Halbleiterschaltung aus mehreren Komponenten, wovon eine Komponente auf einem Hochspannungspotenzial liegt, so ist das Gehäuseteil, das räumlich dieser Komponente am nächsten liegt, diesem Hochspannungspotenzial zuzuweisen.

Bei Halbleiterschaltungen, die an ihren Anschlussklemmen besonders hohe Spannungsdifferenzen aufweisen, beispielsweise von mehr als 10 kV, wird als vorteilhaft angesehen, wenn benachbarte Gehäuseteile in Betrieb jeweils einen Potenzialunterschied zwischen 1 kV und 200 kV oder gar darüber hinaus aufweisen. Auf diese Weise kann eine Abstufung der Spannungsniveaus der Gehäuseteile erreicht werden, die eine Anpassung an die an der Halbleiterschaltung anliegende Spannung ermöglicht. Durch eine geeignete Zuweisung der Potenziale zu den Gehäuseteilen entsprechend ihrer räumlichen Anordnung gegenüber der Halbleiterschaltung bzw. deren Komponenten kann eine besonders kompakte Bauform des Gehäuses erreicht werden.

Gemäß der Erfindung ist das Gehäuse ein Modulrahmen, an dem die Halbleiterschaltung montiert ist. Demnach weist das Gehäuse nicht notwendigerweise eine die Halbleiterschaltung vollständig umschließende Bauform auf. Vielmehr kann es von Vorteil sein, dass das Gehäuse als Modulrahmen ausgebildet ist. Der Modulrahmen umrahmt die Halbleiterschaltung und bietet eine geeignete Aufhängevorrichtung, an der die Halbleiterschaltung befestigt werden kann. Der Modulrahmen umgreift die Halbleiterschaltung seitlich, er muss jedoch keine vollständige Bedeckung der Halbleiterschaltung von oben und/oder von unten bereitstellen. Durch die Anordnung der Halbleiterschaltung ist sowohl eine gute Kühlwirkung als auch eine besonders gute Zugänglichkeit der Halbleiterschaltung gewährleistet.

Erfindungsgemäß umfasst der Modulrahmen mehrere Rahmensegmente, die mittels Isolatorbauteilen voneinander getrennt sind. Die Gehäuseteile in Form von Rahmensegmenten können beispielsweise plattenförmig sein. Zur Isolation der Rahmensegmente untereinander sind jeweils zwischen zwei Rahmensegmenten, denen unterschiedliche Potenziale zugewiesen werden sollen, die Isolatorbauteile vorgesehen. Die Isolatorbauteile sind an den Rahmensegmenten montiert und umfassen elektrisch isolierende Abstandshalter. Auf diese Weise ist eine besonders einfache und wirkungsvolle Aufteilung der Potenziale am Gehäuse ermöglicht.

Gemäß einer vorteilhaften Ausführungsform der Erfindung weist der Modulrahmen eine C-Form auf. Demnach ist der Modulrahmen zumindest in einer räumlichen Ebene derart ausgestaltet, dass er dem Buchstaben C ähnelt. Dazu weist der Modulrahmen in dieser Ebene eine einseitige Einbuchtung auf, die dreiseitig zumindest teilweise begrenzt ist. Ein besonderer Vorteil dieser Ausführungsform ergibt sich beispielsweise, wenn zwei der elektrischen Einrichtungen einander gegenüber angeordnet sind, wobei die Einbuchtungen der C-förmigen Modulrahmen der beiden Einrichtungen einander zugewandt sind. Damit ist zwischen den beiden Einrichtungen ein Freiraum gebildet. Dieser Freiraum kann vorteilhaft dazu genutzt werden, einen zusätzlichen Zugang für Wartungsarbeiten an den Halbleiterschaltungen zu ermöglichen. Beispielsweise kann eine Hebebühne vorgesehen sein, die in dem Freiraum angeordnet ist und einer entsprechenden Zugänglichkeit bei Wartungsarbeiten dient.

Gemäß der Erfindung weist die Halbleiterschaltung eine Reihenschaltung von Leistungshalbleitern auf. Eine solche Reihenschaltung hat üblicherweise zur Folge, dass im Betrieb der elektrischen Einrichtung zwischen den Anschlussklemmen der Reihenschaltung eine Spannungsdifferenz anliegt. Diese Spannungsdifferenz kann bei Hochspannungsanwendungen im Bereich von über 10 kV oder gar über 200 kV liegen. Dies hat zur Folge, dass ein erster Leistungshalbleiter in der Reihenschaltung auf einem niedrigen Potenzial liegen kann, beispielsweise auf Erdpotenzial, wohingegen ein letzter Leistungshalbleiter in der Reihenschaltung auf einem Hochspannungspotenzial, beispielsweise von weit über 100 kV liegen kann. In diesem Fall ist die Aufteilung der Potenziale am Gehäuse besonders wirkungsvoll. Den Gehäuseteilen können abgestufte Spannungs- bzw. Potenzialniveaus zugewiesen werden, so dass kompakte Abmessungen der einzelnen Gehäuseteile realisierbar sind. Der Leistungshalbleiter auf höchstem Potenzial muss dann nicht für die gesamte Potenzialdifferenz zwischen Erdpotenzial und Hochspannungspotenzial gegenüber einem Gehäuse auf Erdpotenzial isoliert werden.

Eine besonders günstige Anwendbarkeit der Erfindung ergibt sich, wenn die Halbleiterschaltung Thyristoren umfasst. Beispielsweise kann wenigstens einer der Leistungshalbleiter der Reihenschaltung ein Thyristor sein. Thyristoren werden oft in Hochspannungsumrichtern eingesetzt, weil diese Halbleiterschalter eine besonders hohe Sperrfähigkeit aufweisen können. Die Sperrfähigkeit der Thyristoren bzw. der anderen Leistungshalbleiter in einer vorteilhaften Anwendung der Erfindung kann beispielsweise zwischen 1 kV und 8 kV oder mehr betragen.

Vorteilhaft ist jedem Thyristor in der Reihenschaltung eine RC-Beschaltung und/oder eine Ventildrossel zugeordnet. Die RC-Beschaltung umfasst ein Widerstandselement und einen Kondensator, die geeigneterweise parallel zum Thyristor angeordnet sind. Die RC-Beschaltung ist mit jedem Thyristor im Gehäuse angeordnet.

Beispielsweise kann eine Reihenschaltung von Leistungshalbleitern zumindest teilweise in einem Modulgehäuse untergebracht sein, das mehrere im Betrieb des Umrichters auf unterschiedlichen elektrischen Potenzialen liegende Gehäuseteile umfasst.

Die Vorteile des erfindungsgemäßen Umrichters ergeben sich aus den zuvor beschriebenen Vorteilen der erfindungsgemäßen elektrischen Einrichtung.

Alle zuvor beschriebenen Varianten und Ausführungsformen der erfindungsgemäßen elektrischen Einrichtung können selbstverständlich allein oder in Kombination miteinander im erfindungsgemäßen Umrichter eingesetzt werden.

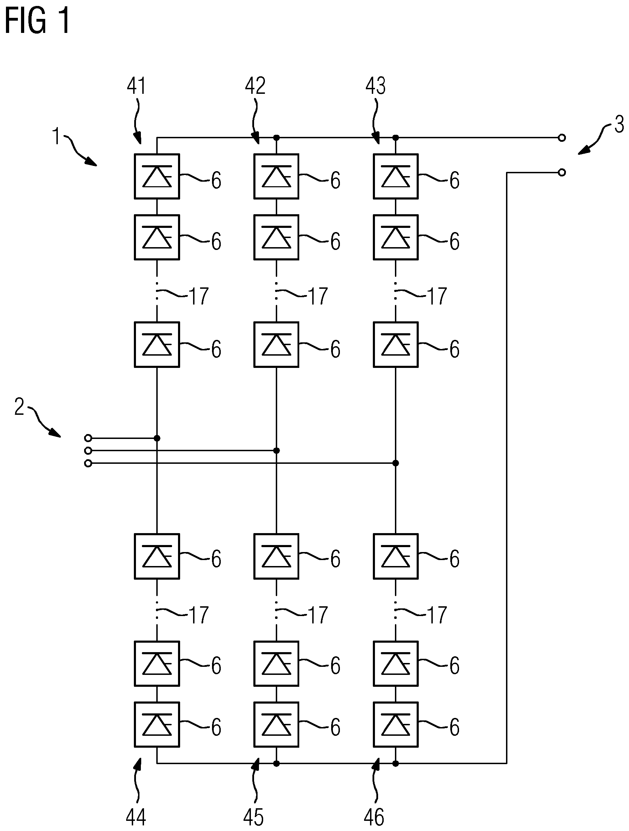

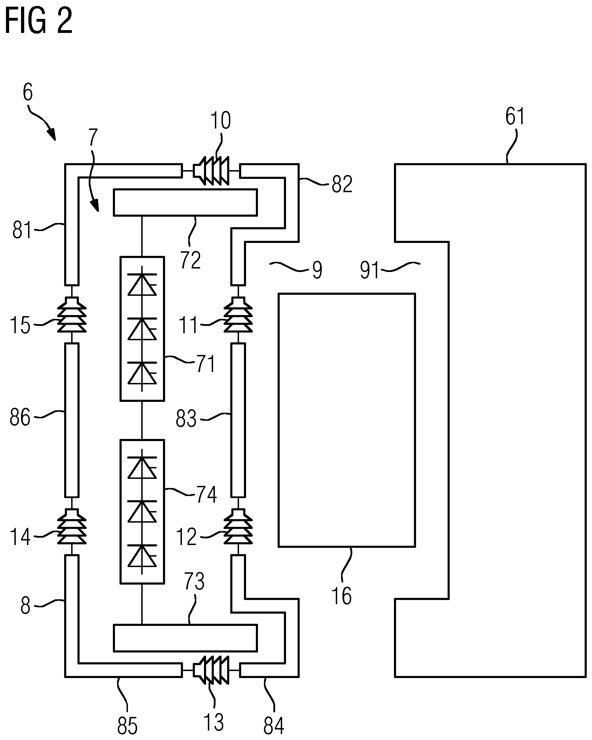

Die Erfindung wird im Folgenden anhand von in Figuren 1 und 2 dargestellten Ausführungsbeispielen der erfindungsgemäßen elektrischen Einrichtung und des erfindungsgemäßen Umrichters weiter erläutert.
Figur 1 zeigt ein Ausführungsbeispiel eines erfindungsgemäßen Umrichters in einer schematischen Darstellung;
Figur 2 zeigt ein Ausführungsbeispiel einer erfindungsgemäßen elektrischen Einrichtung in einer schematischen Draufsicht.

Im Einzelnen ist in Figur 1 ein Umrichter 1 dargestellt. Der Umrichter 1 weist eine Wechselspannungsseite mit einem Wechselspannungsanschluss 2 zum Anschluss an ein dreiphasiges Wechselspannungsnetz auf. Ferner weist der Umrichter 1 eine Gleichspannungsseite mit einem Gleichspannungsanschluss 3 zum Anschluss an eine Gleichspannungsleitung auf. Der Umrichter 1 umfasst drei Phasenzweige, die auch als Ventilzweige 41-46 bezeichnet werden. Jeder der Ventilzweige 41-46 weist eine Reihenschaltung von Thyristormodulen 6 auf. Eine unterbrochene Linie 17 in jedem Ventilzweig 41-46 verdeutlicht, dass im Allgemeinen dort mehr als die drei explizit dargestellten Thyristormodule angeordnet sein können.

Jedes Thyristormodul 6 ist eine elektrische Einrichtung mit einer Reihenschaltung mehrerer Thyristoren, die zusammen mit einer zugehörigen Thyristorbeschaltung und Ventildrosseln in einem Gehäuse angeordnet sind.

Auf den Aufbau des Thyristormoduls 6 wird in der folgenden Figur 2 näher eingegangen.

Figur 2 zeigt eine elektrische Einrichtung in Form eines Thyristormoduls 6. Das Thyristormodul 6 umfasst eine Halbleiterschaltung 7, die einen ersten Thyristorbaustein 71, einen zweiten Thyristorbaustein 74 und eine obere und eine untere Ventildrossel 72 bzw. 73 umfasst. Der erste und zweite Thyristorbaustein 71 bzw. 74 umfassen jeweils eine Reihenschaltung von Thyristoren und eine zugehörige Thyristorbeschaltung.

Die Halbleiterschaltung 7 ist in einem Gehäuse in Form eines Modulrahmens 8 angeordnet. Der Modulrahmen 8 weist mehrere Rahmensegmente 81-86 auf. Die Rahmensegmente 81-86 sind derart um die Halbleiterschaltung 7 angeordnet, dass sie eine C-Form mit einer Einbuchtung 9 in der Zeichenebene der Figur 2 bilden. In dem in Figur 2 dargestellten Ausführungsbeispiel umfasst der Modulrahmen 8 sechs Rahmensegmente 81-86. Im Allgemeinen kann deren Anzahl und Größe beliebig variieren und an die jeweilige Anwendung und die Ausgestaltung der Halbleiterschaltung 7 angepasst sein.

Die Rahmensegmente 81-86 sind voneinander mittels Isolierbauteilen in Form von isolierenden Abstandshaltern 10-15 elektrisch isoliert. Aufgrund der Isolierung können den Rahmensegmenten 81-86 jeweils unterschiedliche elektrische Potenziale zugewiesen werden. Damit kann jedes Rahmensegment 81-86 im Betrieb des Thyristormoduls 6 ein eigenes, vordefiniertes Potenzialniveau aufweisen.

Sind beispielsweise die Ventildrossel 73 mit einem auf einem negativen Potenzial liegenden Pol und die Ventildrossel 72 mit einem auf demgegenüber positiveren Potenzial liegenden Pol verbunden, so kann dem Rahmensegment 81 ein höheres Potenzial als dem Rahmensegment 85 zugewiesen werden. Auf diese Weise können die Isolationsabstände zwischen der oberen Ventildrossel 72 bzw. zumindest einem Teil des ersten Thyristorbausteins 71 und dem Rahmensegment 81 verhältnismäßig gering gewählt sein. Ebenso können die Isolationsabstände zwischen der unteren Ventildrossel 73 bzw. zumindest einem Teil des zweiten Thyristorbausteins 74 und dem Rahmensegment 85 verhältnismäßig gering gewählt sein.

In dem in Figur 2 dargestellten Ausführungsbeispiel ist gegenüber dem Thyristormodul 6 ein weiteres Thyristormodul 61 angeordnet. Das Thyristormodul 6 und das weitere Thyristormodul 61 sind gleichartig aufgebaut, so dass auf den Aufbau des weiteren Thyristormoduls 61 nicht näher eingegangen werden muss. Die Einbuchtung 9 des Thyristormoduls 6 und eine Einbuchtung 91 des weiteren Thyristormoduls 61 sind einander zugewandt. In dem durch die beiden Einbuchtungen 9, 91 gebildeten Freiraum ist eine Hebebühne 16 angeordnet. Die Hebebühne 16 kann senkrecht zur Zeichenebene der Figur 2 bewegt werden. Somit können mittels der Hebebühne 16 sowohl die Thyristormodule 6 und 61 als auch räumlich über diesen angeordnete, grafisch nicht dargestellte Thyristormodule erreicht werden. Die Zugänglichkeit der Thyristormodule bzw. der Halbleiterschaltungen zu Installations- und Wartungszwecken ist auf diese Weise stark verbessert.

## Patentansprüche

1. Umrichter (1) mit einer elektrischen Einrichtung (6) mit einer Halbleiterschaltung (7) zwischen einem Wechselspannungsanschluss (2) und einem Gleichspannungsanschluss (3), die für eine Hochspannung ausgelegt und in einem Gehäuse (8) angeordnet ist, wobei die Halbleiterschaltung (7) eine Reihenschaltung (71,74) von Leistungshalbleitern aufweist, wobei das Gehäuse (8) ein Modulrahmen ist, an dem die Halbleiterschaltung (7) montiert ist, und mehrere Gehäuseteile (81-86) umfasst, die Rahmensegmente (81-86) sind, die mittels Isolatorbauteilen (10-15) voneinander getrennt und damit voneinander elektrisch isoliert sind, wobei die Isolatorbauteile (10-15) an den Rahmensegmenten montiert sind und elektrisch isolierende Abstandshalter umfassen, wobei den Rahmensegmenten (81-86) unterschiedliche elektrische Potenziale zuweisbar sind.

2. Umrichter (1) nach Anspruch 1, wobei wenigstens ein Rahmensegment (81-86 dafür vorgesehen ist, in Betrieb auf einem Hochspannungspotenzial zu liegen.

3. Umrichter (1)nach einem der Ansprüche 1 oder 2, wobei benachbarte Rahmensegmente (81-86) dafür vorgesehen sind, in Betrieb jeweils einen Potenzialunterschied zwischen 1 kV und 200 kV aufzuweisen

4. Umrichter (1)nach einem der vorangehenden Ansprüche, wobei der Modulrahmen (8) eine C-Form aufweist.

5. Umrichter (1)nach Anspruch 1, wobei wenigstens einer der Leistungshalbleiter ein Thyristor ist.

6. Umrichter (1)nach einem der Ansprüche 4 oder 5, wobei jeder der Leistungshalbleiter eine elektrische Sperrfähigkeit von mindestens 1 kV aufweist.

7. Umrichter (1)nach einem der Ansprüche 5 oder 6, wobei jedem Thyristor eine RC-Beschaltung und/oder eine Ventildrossel zugeordnet ist.

## Claims

1. Converter (1) having an electrical device (6) with a semiconductor circuit (7) between an AC voltage supply (2) and a DC voltage supply (3), which is designed for a high voltage and is arranged in a housing (8), wherein the semiconductor circuit (7) has a series connection (71, 74) of power semiconductors,
wherein
the housing (8) is a module frame on which the semiconductor circuit (7) is mounted, and comprises a plurality of housing parts (81-86) which are frame segments (81-86) which are separated from one another by means of insulator components (10-15) and are thus electrically insulated from one another, wherein the insulator components (10-15) are mounted on the frame segments and comprise electrically insulating spacers, wherein different electrical potentials can be assigned to the frame segments (81-86).

2. Converter (1) according to claim 1, wherein at least one frame segment (81-86) is intended to be at a high voltage potential during operation.

3. Converter (1) according to any one of claims 1 or 2, wherein adjacent frame segments (81-86) are provided to each have a potential difference between 1 kV and 200 kV in operation.

4. Converter (1) according to one of the preceding claims, wherein the module frame (8) has a C-shape.

5. Converter (1) according to claim 1, wherein at least one of the power semiconductors is a thyristor.

6. Converter (1) according to any one of claims 4 or 5, wherein each of the power semiconductors has an electrical blocking capability of at least 1kV.

7. Converter (1) according to any one of claims 5 or 6, wherein each thyristor is assigned an RC circuit and/or a valve choke.

## Revendications

1. Convertisseur (1) comprenant un appareil électrique (6) doté d'un circuit à semiconducteurs (7) entre une alimentation en tension alternative (2) et une alimentation en tension continue (3), qui est conçu pour une haute tension et est disposé dans un boîtier (8), dans lequel le circuit à semiconducteurs (7) présente une connexion en série (71, 74) de semiconducteurs de puissance,
dans lequel
le boîtier (8) est un boîtier sur lequel le circuit à semiconducteurs (7) est monté et comprend une pluralité de parties de boîtier (81 à 86) qui sont des segments de cadre (81 à 86) qui sont séparés les uns des autres au moyen de composants isolants (10 à 15) et sont ainsi isolés électriquement les uns des autres, les composants isolants (10 à 15) étant montés sur les segments de cadre et comprenant des entretoises électriquement isolantes, dans lequel différents potentiels électriques peuvent être attribués aux segments de cadre (81 à 86).

2. Convertisseur (1) selon la revendication 1, dans lequel au moins un segment de cadre (81 à 86) est destiné à être à un potentiel haute tension en fonctionnement.

3. Convertisseur (1) selon l'une quelconque des revendications 1 ou 2, dans lequel des segments de cadre adjacents (81 à 86) sont prévus pour présenter chacun une différence de potentiel comprise entre 1 kV et 200 kV en fonctionnement.

4. Convertisseur (1) selon l'une des revendications précédentes, dans lequel le cadre de module (8) a une forme en C.

5. Convertisseur (1) selon la revendication 1, dans lequel au moins un des semiconducteurs de puissance est un thyristor.

6. Convertisseur (1) selon l'une quelconque des revendications 4 ou 5, dans lequel chacun des semiconducteurs de puissance a une capacité de blocage électrique d'au moins 1kV.

7. Convertisseur (1) selon l'une quelconque des revendications 5 ou 6, dans lequel à chaque thyristor est associé un circuit RC et/ou une inductance de vanne.
